# EUROPEAN PATENT SPECIFICATION

(11) **EP 1 630 853 B1**
(45) Date of publication and mention of the grant of the patent: **17.12.2008**
(21) Application number: 05014844.4
(22) Date of filing: 08.07.2005
(51) Int. Cl.: H01J 65/04, H05B 41/28, H01L 21/00, G02F 1/1333

(54) **An operating device for an excimer lamp**
Betriebsgerät für Excimerlampe
Dispositif d'opération pour une lampe excimère

(30) Priority: 25.08.2004 JP 2004245455
(43) Date of publication of application: 01.03.2006
(73) Proprietor: USHIODENKI KABUSHIKI KAISHA, Chiyoda-ku 100 Tokyo (JP)
(72) Inventor: Nakamura, Masaki, Himeji Hyogo-ken (JP); Yamamori, Kenji, Himeji Hyogo-ken (JP)
(74) Representative: Tomerius, Isabel

(56) References cited:
- EP-A- 1 158 574
- WO-A2-02/49395
- JP-A- 6 061 146
- JP-A- 2004 162 133

## Description

### Background of the Invention

### Field of the Invention

The invention relates to an operating device for an excimer lamp. The invention relates especially to a method for heating the window part in an operating device for an excimer lamp which comprises a window part between an object to be irradiated and the excimer lamp.

### Description of the Prior Art

Recently, an operating device for an excimer lamp is increasingly being used in the production process of semiconductors for cleaning liquid crystal substrates by employing an excimer lamp and for similar purposes, in which lamp the luminous energy is strong and with which light can be radiated with a single wavelength with high efficiency. A window part for allowing UV radiation to pass is generally arranged in an operating device for an excimer lamp when using an excimer lamp as a UV light source. An operating device for an excimer lamp in which a window part consisting of quartz glass is arranged for example between a lamp housing provided with several excimer lamps and an object to be irradiated is known from an apparatus described in the Japanese published application HEI 8-85861.

JP 06-061146 A discloses a system wherein UV light from a light source, such as an excimer laser or an arc lamp, is introduced through a quartz window into a reaction chamber. The quartz window is heated to prevent adherence of reaction products thereon. In one embodiment, ferromagnetic particles such as iron, cobalt or nickel, are mixed into the quartz material of the window, and an RF coil is provided to generate an eddy current in the conductor formed by these particles, thereby heating the window. The effect is reinforced by hysteresis loss of the ferromagnetic material.

In the case of an operating device for an excimer lamp in which a window part is arranged between the lamp housing and the object to be irradiated it is regarded as being disadvantageous that a reaction product will adhere to the side of the object to be irradiated of the window part, which reaction product is obtained as a result of a photolysis by excimer light. As a technique for preventing such adherence of the reaction product, an arrangement of a thick-film heating apparatus or a linear heating apparatus in the window part is described in the Japanese published application HEI 11-295500 (EP 1158574 A).

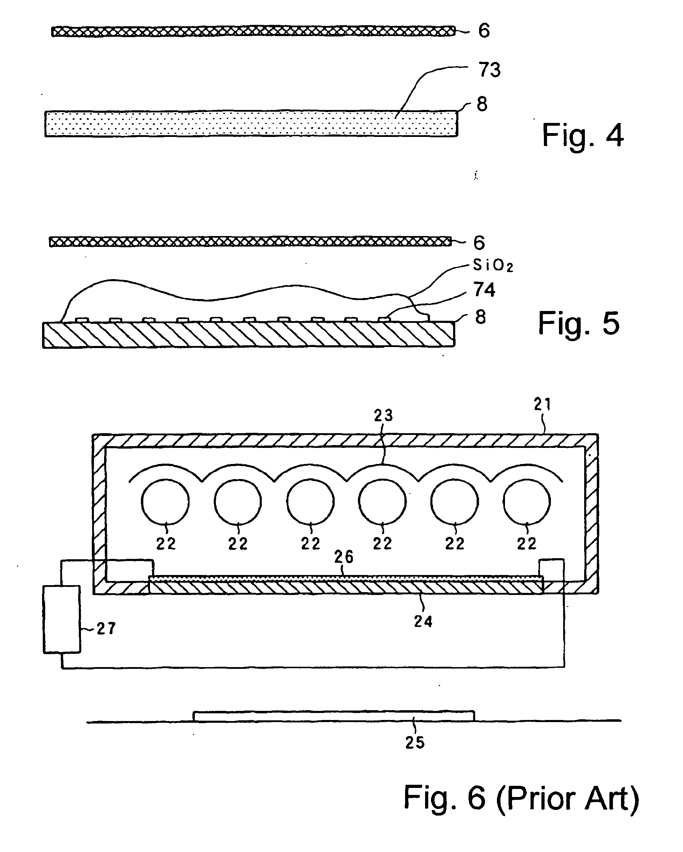

Fig. 6 schematically shows the arrangement of an operating device for an excimer lamp according to the state of the art. In this operating device, a reflector 23 is arranged in a lamp housing 21 on the rear side of an excimer lamp 22, which reflector is used to focus the excimer light emitted by the excimer lamp 22 with a high amount of efficiency. The excimer light emitted by the excimer lamps 22 and the reflectors 23 is emitted by a window part 24 arranged in the lamp housing 21 to the side of an object 25 to be irradiated. Furthermore, a thick-film heating apparatus 26 is formed on the excimer lamp side of the window part 24 as a means for heating the window part 24, which heating apparatus was applied with an electrically conductive heat-generating paste by screen printing. Moreover, resistance heating by a linear heating apparatus or the like can be used as a heating means in addition to the thick-film heating apparatus. In this thick-film heating apparatus 26, a power is supplied from a power source 27 such as a DC source, a mains power source or the like, which is arranged outside of the lamp housing. Heating is provided by activating the thick-film heating apparatus 26.

In order to switch on the thick-film heating apparatus 26 for heating the window part 24 and thus to perform a heating as in the operating device for excimer lamps according to the aforementioned state of the art, it is necessary to provide a power source 27 such as a DC source, a mains power source or the like in addition to the high-frequency high-voltage power source for operating the operating device for the excimer lamp. This led to the disadvantage that the main power circuit in operating devices for excimer lamps were complex and large. An additional disadvantage was that there was always the likelihood that the thick-film heating apparatus 26 or the like would blow and that the heating of the same would have to be ceased completely as a result of the blow-out of a part of the same.

### Summary of the Invention

The invention was made in order to eliminate the aforementioned disadvantages in the state of the art. It is the object of the present invention to provide an operating device for excimer lamps in which a heating apparatus for suppressing the adherence of a reaction product on the window part for allowing the passage of excimer light, which product was produced on the side of the object to be irradiated, but in which a main power circuit for supplying an input power to said heating apparatus is made neither too complicated nor too large in which as a result the arrangement of the switching system for the apparatus is simplified.

The object as described above is achieved in accordance with the invention by the operating device for excimer lamps according to claim 1. Preferred embodiments are described in the dependent claims.

In a development, the said conductor for an induction heating consists of several metal loops which are arranged along the surface of the window part on the side of the excimer lamps.

Another further development consists of an operating device for excimer lamps which is characterized in that the said conductor for an induction heating is a metallic body which was mixed with the material of the window part.

A further development consists of an operating device for excimer lamps which is characterized in that a switching device is arranged in one of the embodiments as described above, in which in the off state of the excimer lamp(s) the induction heating coil is supplied by the power source.

As a result of the operating device for excimer lamps as described in claim 1, the window part comprises an induction heating coil which is supplied by the power source for operating the excimer lamp(s) and a conductor for an induction heating which is subjected to induction heating by the induction heating coil and which is formed in such a way that the excimer light is allowed to pass through the window part and heats the window part. This measure ensures that the power source for supplying power to the induction heating coil which heats the window part is uniform with the power source for operating the excimer lamps, as a result of which the circuitry configuration of the operating device for excimer lamps is simplified. As a result, a reduction in the size of the operating device for excimer lamps is enabled.

Preferably, the conductor for an induction heating is formed by several metal loops which are arranged along the surface of the window part on the side of the excimer lamps. Therefore, the metal loops for an induction heating are arranged on the surface of the glass of which the window part consists. The window part can thus be heated with a high degree of efficiency. It is further also enabled that the window part is cleaned by removing the same from the metal loops.

The conductor for an induction heating can preferably be formed from a metallic material which was mixed with the material of the window part. The conductor for an induction heating can be formed in an integral way with the window part. It is thus enabled that the arrangement of the operating device for excimer lamps is simplified even further.

A switching device is further preferably arranged in which in the deactivated state of the excimer lamps the induction heating coil is supplied by the power source for operating the excimer lamps. It is thus enabled to reliable change over the electric input to the excimer lamps and to the induction heating coil. The window part can only reliably be heated by the induction heating coil in the deactivated state of the excimer lamps and effectively apply the input power.

The invention is explained below in closer detail by reference to an embodiment shown in the drawings, wherein:
- Fig. 1: shows a schematic representation of the arrangement of an embodiment of the operating device for excimer lamps in accordance with the invention;
- Figs. 2 (a) and (b): each show a schematic representation of the concrete arrangement of an induction heating coil 6 and of metal loops 71, 72 for an induction heating as seen from the side of the excimer lamps 5 as shown in Fig. 1;
- Fig. 3: shows a front view of the concrete arrangement of the induction heating coil 6 as shown in Fig. 2(a) and the metal loops 71 for an induction heating;
- Fig. 4: shows a front view of the concrete arrangement when a metal powder 73 is mixed with a window part 8 as a conductor for an induction heating instead of the metal loops 71 for an induction heating according to Fig. 2(a) or Fig. 3;
- Fig. 5: shows a front view of the concrete arrangement when metal pieces 74 are scattered on the surface of the window part 8 as a conductor for an induction heating instead of the metal loops 71 for an induction heating according to Fig. 2(a) or Fig. 3, and
- Fig. 6: shows a schematic representation of the arrangement of an excimer lamp apparatus according to the state of the art.

### Detailed Description

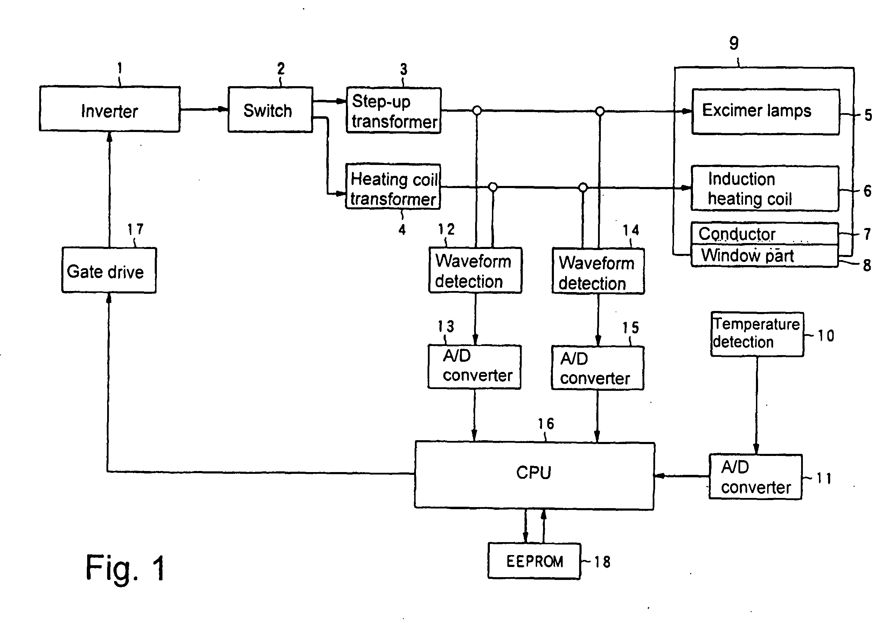

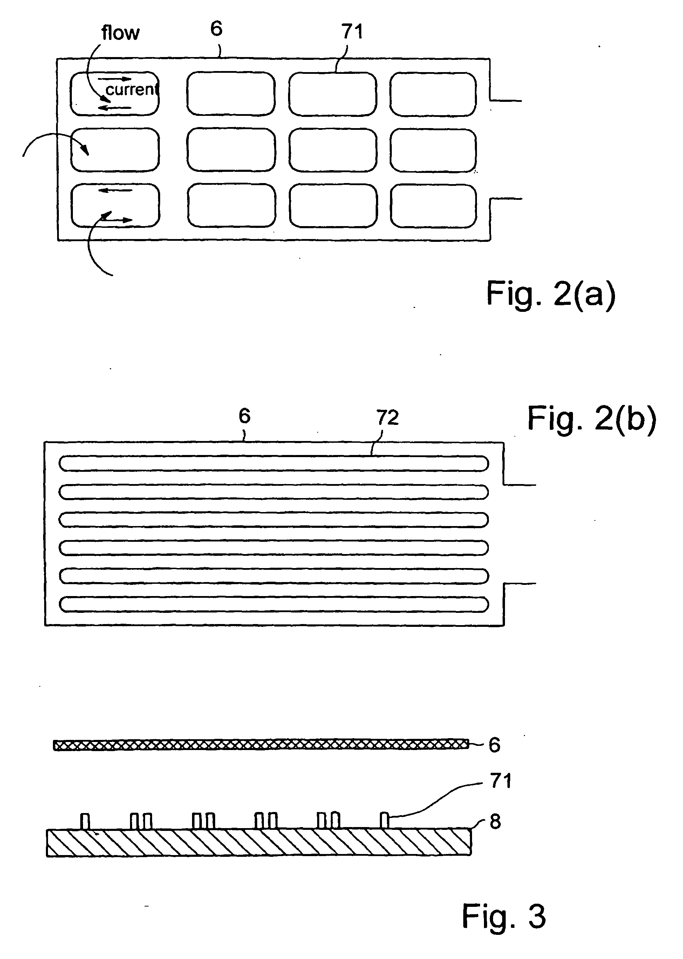

An embodiment of the invention is described below by reference to Fig. 1 and Fig. 2(a) and Fig. 2(b).

Fig. 1 shows a schematic representation of this embodiment of the arrangement of an operating device for excimer lamps in accordance with the invention.

The operating device for excimer lamps comprises an inverter 1 for producing a high-frequency voltage, a changeover switch 2 for changing over the output of the inverter 1 to a step-up transformer 3 or a heating-coil transformer 4, the said step-up transformer 3 for increasing the voltage of the output of the inverter 1 to a high-frequency high voltage for operating excimer lamps 5, and the said heating-coil transformer 4 for regulating the output of the inverter 1 to a voltage which is applied to an induction heating coil 6. The operating device further comprises several excimer lamps 5 which are arranged in a lamp housing 9. The voltage emitted by the heating-coil transformer 4 is applied to the induction heating coil 6 and an induction field is thus generated. As a result of the influence of the induction field as generated by the induction heating coil 6, an induction current flows in the conductor 7 for an induction heating and heat is generated. The window part 8 is thus heated. The window part 8 consists of glass, is arranged in the lamp housing 9 and allows excimer light to pass which is emitted by the excimer lamps 5 and the reflectors (not shown in the drawing). The object to be irradiated is not shown here. Excimer lamps 5, induction heating coil 6, the conductor 7 for an induction heating and the like are arranged in the lamp housing 9. Finally, the operating device for excimer lamps comprises a temperature detection circuit 10, an analog-to-digital converter 11, a voltage waveform detection circuit 12, a further analog-to-digital converter 13, a current waveform detection circuit 14, a further analog-to-digital converter 15, an arithmetic unit (CPU) 16, a gate drive 17 and an EEPROM 18.

Fig. 2(a) and Fig. 2(b) each show schematically the concrete arrangement of the induction heating coil 6 and the metal loops 71, 72 for an induction heating as a conductor 7 for an induction heating, which are each seen from the side of the excimer lamps 5 as shown in Fig. 1. Fig. 3 shows a schematic representation of the concrete arrangement of the induction heating coil 6 as seen from the front side and the metal loops 71 for an induction heating according to Fig. 2(a).

As is shown in the drawings, an induction current flows in the metal loops 71, 72 for an induction heating by action of an induction field generated by the induction heating coil 6. Heat is thus produced, by which the window part 8 is heated.

A metal net can be arranged on the window surface as a conductor 7 for an induction heating instead of the metal loops 71 as shown in Fig. 3. As is further shown in Fig. 4, a metal powder 73 can be mixed with the window part 8 consisting of glass, an eddy current can be produced in said metal powder 73 and heat can thus be generated. Advantageous as a metal powder 73 in this respect is a metal with a melting point of higher than or equal to 1600 °C such as molybdenum, tungsten or the like. The grain size of the metal powder 73 is at approximately 1 µm up to a few millimeters. The mixing quantity is defined by a numerical aperture of higher than or equal to 90 %, which means it is defined by a quantity by which the reduction of the illuminance in the object to be irradiated is smaller than or equal to 10 % in a window part 8 made of glass in which the mixing was performed in comparison with a window part 8 made of glass without mixing. If approximately 10 ppm of substantially spherical material is contained with a grain size of 1 µm for example, the numerical aperture lies at approximately 90 %. As is further shown in Fig. 5, metal pieces 74 can be distributed over the surface of the window part 8 made of glass and cover the same with SiO₂ as a conductor 7 for an induction heating.

The operation of the operating device for excimer lamps is described below by reference to Fig. 1 and Fig. 2(a) and (b).

The operation of this apparatus comprises an illuminating operating mode and an induction heating mode. The respective mode is carried out by a changeover of the changeover switch 2. In the illuminating operating mode, a high-frequency voltage is applied by the inverter 1 to the step-up transformer 3, from which a high-frequency high voltage is output which is applied to the excimer lamps 5, as a result of which the excimer lamps 5 are operated. By changing over the changeover switch 2, a high-frequency voltage (e.g. 10 kHz to 100 kHz) is applied to the induction heating coil 6 via the heating coil transformer 4 in the deactivated state of the lamps, which means in the induction heating mode. The induction field induced by the induction heating coil 6 acts upon the metal loops 71 or 72 according to Fig. 2(a) and (b) as a conductor 7 for an induction heating. An induction current thus flows in the metal loops 71 or 72 and heat is generated. The window part 8 can thus be heated.

The temperature detection circuit 10 is a circuit for determining the temperature of the window part 8. It converts the temperature into electric signals, adjusts the signal size in a predetermined way, converts them into digital signals via the analog-to-digital converter 11 and enters them into the arithmetic unit (CPU) 16.

The voltage waveform detection circuit 12 is a circuit for determining a voltage waveform which is supplied to the excimer lamps 5. It adjusts the signal size in a predetermined manner, converts them into digital signals via the analog-to-digital converter 13 and enters them into the arithmetic unit (CPU) 16.

The current waveform detection circuit 14 adjusts the current supplied to the excimer lamps 5 to a predetermined voltage level, converts them into digital signals via the analog-to-digital converter 15 and enters them into the arithmetic unit (CPU) 16.

The arithmetic unit (CPU) 16 calculates the signals from the analog-to-digital converters 11, 13, 15 and sends control signals to the gate drive 17 which operates the inverter 1. The arithmetic unit (CPU) 16 is provided with an EEPROM 18 which is used for storing the result of the respective calculation and the comparison waveforms.

## Claims

1. An operating device for excimer lamps, comprising:
- at least one excimer lamp (5) with a discharge space in which rare gas is filled;
- a power source for operating the at least one excimer lamp (5) comprising an inverter (1) for producing a high-frequency voltage;
- a lamp housing (9) in which the at least one excimer lamp (5) is arranged and which comprises a window part (8) made of glass transparent for excimer light emitted by the at least one excimer lamp (5);
**characterized in that**
the window part (8) is provided with an induction heating coil (6) supplied by the power source for operating the at least one excimer lamp (5) by applying high-frequency voltage from the inverter (1), and with a conductor (7) for an induction heating and the conductor (7) for an induction heating being configured in such a way that the excimer light is allowed to pass through the window part (8), such that it is subjected by the induction heating coil (6) to an induction heating, as a result of which the window part (8) is heated.

2. An operating device for excimer lamps according to claim 1,
**characterized in that** the conductor (7) for an induction heating consists of several metal loops (71, 72) which are arranged along the surface of the window part (8) on the side of the at least one excimer lamp (5).

3. An operating device for excimer lamps according to claim 1,
**characterized in that** the conductor (7) for an induction heating consists of a metallic net which is arranged at least in sections over the surface of the window part (8) on the side of the at least one excimer lamp (5).

4. An operating device for excimer lamps according to claim 1,
**characterized in that** the conductor (7) for an induction heating is obtained in such a way that metal particles (73) are mixed into the material of the window part (8).

5. An operating device for excimer lamps according to claim 4,
**characterized in that** the metal particles (73) consist of a metal with a melting point of higher than or equal to 1600°C and consist especially of molybdenum or tungsten.

6. An operating device for excimer lamps according to claim 1,
**characterized in that** the conductor (7) for an induction heating consists of metal particles (74) which are distributed over the surface of the window part (8) and are covered with a layer transparent for excimer light.

7. An operating device for excimer lamps according to claim 6,
**characterized in that** the layer consists mainly of molten silicon dioxide.

8. An operating device for excimer lamps according to one of the claims 1 to 7,
**characterized in that** it comprises a switching device (2) which switches the power source for operating the at least one excimer lamp (5) in such a way that it supplies the induction heating coil (6) with power only in the deactivated state of the at least one excimer lamp (5).

9. An operating device for excimer lamps according to one of the claims 1 to 8,
**characterized in that** it comprises several excimer lamps (5) in the lamp housing (9).

## Patentansprüche

1. Betätigungsvorrichtung für Excimer-Lampen, die Folgendes umfasst:
mindestens eine Excimer-Lampe (5) mit einem Entladungsraum, in den Edelgas gefüllt ist; eine Stromquelle zum Betrieb der mindestens einen Excimer-Lampe (5), die einen Wechselrichter (1) zur Erzeugung einer Hochspannung umfasst;
ein Lampengehäuse (9), in dem mindestens eine Excimer-Lampe (5) angeordnet ist und die einen Fensterteil (8) umfasst, der aus Glas besteht, das für das von der mindestens einen Excimer-Lampe (5) abgegebene Excimerlicht durchlässig ist;
**dadurch gekennzeichnet, dass**
der Fensterteil (8) mit einer Induktionsheizspule (6) ausgestattet ist, die von der Stromquelle zum Betrieb der mindestens einen Excimer-Lampe (5) durch Anlegen einer Hochspannung vom Wechselrichter (1) versorgt wird, und ferner mit einem Leiter (7) für eine Induktionsheizung, wobei der Leiter (7) für eine Induktionsheizung so konfiguriert ist, dass das Excimerlicht durch den Fensterteil (8) gehen kann, so dass dieser durch die Induktionsheizspule (6) einer Induktionsheizung ausgesetzt ist, die eine Erwärmung des Fensterteils (8) zur Folge hat.

2. Betätigungsvorrichtung für Excimer-Lampen gemäß Anspruch 1,
**dadurch gekennzeichnet, dass**
der Leiter (7) für eine Induktionsheizung aus mehreren Metallschleifen (71, 72) besteht, die entlang der Oberfläche des Fensterteils (8) auf der Seite der mindestens einen Excimer-Lampe (5) angeordnet sind.

3. Betätigungsvorrichtung für Excimer-Lampen gemäß Anspruch 1,
**dadurch gekennzeichnet, dass**
der Leiter (7) für eine Induktionsheizung aus einem Metallnetz besteht, das zumindest in Abschnitten über der Oberfläche des Fensterteils (8) auf der Seite der mindestens einen Excimer-Lampe (5) angeordnet ist.

4. Betätigungsvorrichtung für Excimer-Lampen gemäß Anspruch 1,
**dadurch gekennzeichnet, dass**
der Leiter (7) für eine Induktionsheizung dergestalt gewonnen wird, dass Metallpartikel (73) in das Material des Fensterteils (8) gemischt werden.

5. Betätigungsvorrichtung gemäß Anspruch 4,
**dadurch gekennzeichnet, dass**
die Metallpartikel (73) aus einem Metall bestehen, dessen Schmelzpunkt größer oder gleich 1600°C ist, und dass sie insbesondere aus Molybdän oder Wolfram bestehen.

6. Betätigungsvorrichtung für Excimer-Lampen gemäß Anspruch 1,
**dadurch gekennzeichnet, dass**
der Leiter (7) für eine Induktionsheizung aus Metallpartikeln (74) besteht, die über der Oberfläche des Fensterteils (8) verteilt und mit einer für Excimerlicht durchlässigen Schicht bedeckt sind.

7. Betätigungsvorrichtung für Excimer-Lampen gemäß Anspruch 6,
**dadurch gekennzeichnet, dass**
die Schicht hauptsächlich aus geschmolzenem Siliciumdioxid besteht.

8. Betätigungsvorrichtung für Excimer-Lampen gemäß einem der Ansprüche 1 bis 7,
**dadurch gekennzeichnet, dass**
diese eine Schaltvorrichtung (2) umfasst, die die Stromquelle zum Betrieb der mindestens einen Excimer-Lampe (5) so schaltet, dass diese die Induktionsheizspule (6) nur im deaktivierten Zustand der mindestens einen Excimer-Lampe (5) mit Strom versorgt.

9. Betätigungsvorrichtung für Excimer-Lampen gemäß einem der Ansprüche 1 bis 8,
**dadurch gekennzeichnet, dass**
sie mehrere Excimer-Lampen (5) im Lampengehäuse (9) umfasst.

## Revendications

1. Dispositif d'actionnement pour lampes à excimère, comprenant :
au moins une lampe à excimère (5) avec un espace de décharge rempli de gaz rare ;
une source d'énergie pour faire fonctionner l'au moins une lampe à excimère (5) comprenant un inverseur (1) pour produire une tension à haute fréquence ;
un corps de lampe (9) dans lequel l'au moins une lampe à excimère (5) est disposée et qui comprend une partie formant fenêtre (8) faite de verre transparent à la lumière d'excimère émise par l'au moins une lampe à excimère (5) ;
**caractérisé en ce**
**que** la partie formant fenêtre (8) est dotée d'un serpentin de chauffage par induction (6) alimenté par la source d'énergie pour faire fonctionner l'au moins une lampe à excimère (5) en appliquant une tension à haute fréquence provenant de l'inverseur (1), et d'un conducteur (7) pour un chauffage par induction, lequel conducteur (7) pour un chauffage par induction est configuré de telle manière que la lumière d'excimère peut passer à travers la partie formant fenêtre (8), de telle façon qu'elle est soumise par le serpentin de chauffage par induction (6) à un chauffage par induction, de sorte que la partie formant fenêtre (8) est chauffée.

2. Dispositif d'actionnement pour lampes à excimère selon la revendication 1,
**caractérisé en ce**
**que** le conducteur (7) pour un chauffage par induction se compose de plusieurs boucles métalliques (71, 72) qui sont disposées le long de la surface de la partie formant fenêtre (8) du côté de l'au moins une lampe à excimère (5).

3. Dispositif d'actionnement pour lampes à excimère selon la revendication 1,
**caractérisé en ce**
**que** le conducteur (7) pour un chauffage par induction se compose d'un treillis métallique disposé au moins par sections sur la surface de la partie formant fenêtre (8) du côté de l'au moins une lampe à excimère (5).

4. Dispositif d'actionnement pour lampes à excimère selon la revendication 1,
**caractérisé en ce**
**que** le conducteur (7) pour un chauffage par induction est obtenu de en mélangeant des particules métalliques (73) dans le matériau de la partie formant fenêtre (8).

5. Dispositif d'actionnement pour lampes à excimère selon la revendication 4,
**caractérisé en ce**
**que** les particules métalliques (73) se composent d'un métal ayant un point de fusion supérieur ou égal à 1600°C et se composent en particulier de molybdène ou de tungstène.

6. Dispositif d'actionnement pour lampes à excimère selon la revendication 1,
**caractérisé en ce**
**que** le conducteur (7) pour un chauffage par induction se compose de particules métalliques (74) qui sont réparties sur la surface de la partie formant fenêtre (8) et sont recouvertes d'une couche transparente à la lumière d'excimère.

7. Dispositif d'actionnement pour lampes à excimère selon la revendication 6,
**caractérisé en ce**
**que** la couche se compose principalement de dioxyde de silicium fondu.

8. Dispositif d'actionnement pour lampes à excimère selon l'une des revendications 1 à 7,
**caractérisé en ce**
**qu'**il comporte un dispositif de commutation (2) qui commute la source d'énergie pour faire fonctionner l'au moins une lampe à excimère (5) de telle manière qu'elle ne fournisse de l'énergie au serpentin de chauffage par induction (6) que lorsque l'au moins une lampe à excimère (5) est désactivée.

9. Dispositif d'actionnement pour lampes à excimère selon l'une des revendications 1 à 8,
**caractérisé en ce**
**qu'**il comporte plusieurs lampes à excimère (5) dans le corps de lampe (9).
